(19) Europäisches Patentamt
European Patent Office
Office européen des brevets

(11) **EP 3 609 076 A1**

(12) **EUROPÄISCHE PATENTANMELDUNG**

(43) Veröffentlichungstag:
**12.02.2020 Patentblatt 2020/07**

(51) Int Cl.:
*H02P 29/024* (2016.01)   *H02H 7/08* (2006.01)
*G01R 31/34* (2020.01)   *G01R 27/02* (2006.01)

(21) Anmeldenummer: **19190280.8**

(22) Anmeldetag: **06.08.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **11.08.2018 DE 102018006382**

(71) Anmelder: **Diehl AKO Stiftung & Co. KG**
**88239 Wangen (DE)**

(72) Erfinder:
• **Weinmann, Martin**
**88339 Bad Waldsee (DE)**
• **Schmid, Andreas**
**88239 Wangen im Allgäu (DE)**
• **Tinius, Sebastian**
**91207 Lauf (DE)**

(74) Vertreter: **Diehl Patentabteilung**
**c/o Diehl Stiftung & Co. KG**
**Stephanstraße 49**
**90478 Nürnberg (DE)**

(54) **VERFAHREN ZUM ERKENNEN EINES ISOLATIONSFEHLERS AN EINER MOTORANORDNUNG, VERFAHREN ZUM ERKENNEN EINER MOTORPHASENUNTERBRECHUNG AN EINER MOTORANORDNUNG UND ANTRIEBSSCHALTUNG ZUM ANTREIBEN EINES ELEKTRONISCH KOMMUTIERTEN MOTORS**

(57)   Eine Antriebsschaltung (10) zum Antreiben eines elektronisch kommutierten Motors (12) enthält einen Gleichspannungszwischenkreis (14) und einen mit diesem verbundenen Wechselrichter (16) mit einer Brückenschaltung aus mehreren Leistungsschaltern (M2...7), an den die Motorphasen (U, V, W) einer den Motor (12) enthaltenden Motoranordnung (12, 18) anschließbar sind. In einem Verfahren zum Erkennen eines Isolationsfehlers (R7a..d) an der Motoranordnung (12, 18) wird zunächst mindestens ein positiver oder negativer Leistungsschalters (M2...7) des Wechselrichters (16) eingeschaltet, während alle anderen Leistungsschalter (M2...7) des Wechselrichters (16) ausgeschaltet sind, bevor alle Leistungsschalter (M2...7) des Wechselrichters (16) ausgeschaltet werden. Anschließend wird eine Motorphasenspannung (Uv) mindestens einer ausgewählten Motorphase (V) der Motorphasen (U, V, W) gegen ein Bezugspotenzial (PR) erfasst, während alle Leistungsschalter (M2...7) des Wechselrichters (16) ausgeschaltet bleiben, um anhand eines Spannungsverlaufs der erfassten Motorphasenspannung (Uv) festzustellen, ob ein Isolationsfehler (R7a..d) an einer der Motorphasen (U, V, W) der Motoranordnung (12, 18) vorhanden ist.

Fig. 2

**Beschreibung**

Die vorliegende Erfindung betrifft ein Verfahren zum Erkennen eines Isolationsfehlers an einer Motoranordnung, ein Verfahren zum Erkennen einer Motorphasenunterbrechung an einer Motoranordnung und eine Antriebsschaltung zum Antreiben eines elektronisch kommutierten Motors.

Beim Betrieb eines elektronisch kommutierten Motors über eine Antriebsschaltung kann es auf der Seite des Motors zu verschiedenen Isolationsfehlern kommen. Zu diesen Isolationsfehlern gehören Isolationsfehler der Motorphasen, die beispielsweise durch einen Defekt des Motorkabels oder der Motorwicklung auftreten können. Außerdem kann es durch Isolationsfehler der Motorwicklungen zu einem Isolationsfehler an einem Motorsternpunkt kommen. Im Fall eines Isolationsfehlers kann ein elektrischer Strom auf Erde bzw. den Schutzleiter abfließen, wobei ein solcher Fehlerstrom eine Personengefährdung durch elektrischen Schlag und Brandgefahr darstellen kann. Es ist deshalb ein allgemeines Bestreben, Isolationsfehler bzw. Fehlerströme zuverlässig zu erkennen, um einen weiteren Betrieb zum Beispiel einer Antriebsschaltung für einen elektronisch kommutierten Motor zu verhindern.

Die US 6 043 664 A offenbart ein Verfahren und eine Vorrichtung zur Isolationsfehlererkennung bei einem mehrphasigen Wechselstrommotor, bei denen die Spannungen aller Motorphasen gegen den Schutzleiter gemessen und aufsummiert werden, um aus einem Vergleich der über die Zeit gemittelten Spannungssumme mit einem vorgegebenen Schwellenwert das Vorhandensein eines Isolationsfehlers zu erkennen.

Ferner kann es bei Motoranordnungen zum Beispiel durch durchgetrennte Motorkabel oder durchgebrannte Motorwicklungen auch zu Motorphasenunterbrechungen kommen. Es ist ein allgemeines Bestreben, auch solche Motorphasenunterbrechungen zuverlässig zu erkennen, um einen weiteren Betrieb zum Beispiel einer Antriebsschaltung für einen elektronisch kommutierten Motor zu verhindern.

Es ist die Aufgabe der Erfindung, ein verbessertes Verfahren zum Erkennen eines Isolationsfehlers oder einer Motorphasenunterbrechung an einer Motoranordnung, deren Motorphasen an einer Antriebsschaltung angeschlossen sind, zu schaffen.

Diese Aufgabe wird gelöst durch die Lehre der unabhängigen Ansprüche. Besonders vorteilhafte Ausgestaltungen und Weiterbildungen der Erfindung sind Gegenstand der abhängigen Ansprüche.

Das erfindungsgemäße Verfahren zum Erkennen eines Isolationsfehlers an einer Motoranordnung, deren Motorphasen an einer Antriebsschaltung angeschlossen sind, wobei die Antriebsschaltung einen Gleichspannungszwischenkreis und einen Wechselrichter mit einer Brückenschaltung mit wenigstens einem positiven Leistungsschalter und wenigstens einem negativen Leistungsschalter aufweist, enthält die Schritte des Einschaltens mindestens eines positiven oder negativen Leistungsschalters des Wechselrichters, während alle anderen Leistungsschalter des Wechselrichters ausgeschaltet sind; des Ausschaltens aller Leistungsschalter des Wechselrichters; des Erfassens mindestens einer Motorphasenspannung einer ausgewählten Motorphase der Motorphasen gegen ein Bezugspotenzial, während alle Leistungsschalter des Wechselrichters ausgeschaltet bleiben; und des Feststellens, ob ein Isolationsfehler an einer der Motorphasen der Motoranordnung vorhanden ist, anhand eines Spannungsverlaufs der erfassten Motorphasenspannung.

Das erfindungsgemäße Verfahren zum Erkennen einer Motorphasenunterbrechung an einer Motoranordnung, deren Motorphasen an einer Antriebsschaltung angeschlossen sind, wobei die Antriebsschaltung einen Gleichspannungszwischenkreis und einen Wechselrichter mit einer Brückenschaltung mit wenigstens einem positiven Leistungsschalter und wenigstens einem negativen Leistungsschalter aufweist, enthält die Schritte des Einschaltens mindestens eines positiven oder negativen Leistungsschalters, vorzugsweise aller positiven oder negativen Leistungsschalter des Wechselrichters einzeln nacheinander, während alle anderen Leistungsschalter des Wechselrichters ausgeschaltet sind; des Erfassens mindestens einer Motorphasenspannung einer ausgewählten Motorphase der Motorphasen gegen ein Bezugspotenzial; und des Feststellens, ob eine Motorphasenunterbrechung einer der Motorphasen der Motoranordnung vorliegt, anhand eines Spannungsverlaufs der erfassten Motorphasenspannung.

Beide Fehlererkennungsverfahren der Erfindung beruhen auf der Erkenntnis, dass durch den Anschluss eines Motors an eine Antriebsschaltung auch parasitäre Kapazitäten des Motors bzw. des Motorkabels gegen den Schutzleiter angekoppelt werden, und dass andererseits auch die Antriebsschaltung über Kapazitäten oder einen Netzanschluss mit dem Potenzial des Schutzleiters gekoppelt ist. Durch das Einschalten mindestens eines positiven Leistungsschalters des Wechselrichters in der positiven Halbwelle der Netzspannung, während alle anderen Leistungsschalter des Wechselrichters ausgeschaltet sind, werden diese parasitären Kapazitäten niederohmig und damit auch sehr schnell aufgeladen. In analoger Weise werden durch das Einschalten mindestens eines negativen Leistungsschalters des Wechselrichters in der negativen Halbwelle der Netzspannung, während alle anderen Leistungsschalter des Wechselrichters ausgeschaltet sind, diese parasitären Kapazitäten niederohmig und damit auch sehr schnell entladen.

Anschließend entladen sich diese parasitären Kapazitäten bei ausgeschaltetem Wechselrichter (positive Halbwelle der Netzspannung) bzw. laden sich diese parasitären Kapazitäten auf (negative Halbwelle der Netzspannung). Im Fall eines vorhandenen Isolationsfehlers an den Motorphasen entladen sich die parasitären Kapazitäten auch über diesen Isolationsfehlerwiderstand (positive Halbwelle der Netzspannung) bzw. laden sich diese parasitären Kapazitäten auch über diesen Isolationsfehlerwiderstand auf (negative Halbwelle der Netzspannung), sodass sich die Entladekurve bzw. die Aufladekurve der parasitären Kapazitäten und damit auch der Spannungsverlauf einer beliebigen Motorphasenspannung entsprechend verändern. Die Entladung bzw. Aufladung der parasitären Kapazitäten wird über Fehlerströme aufgrund von Isolationsfehlern insbesondere beschleunigt. Somit kann anhand des Spannungsverlaufs der erfassten Motorphasenspannung erkannt werden, ob ein Isolationsfehler an einer der Motorphasen vorhanden ist. Diese Isolationsfehlererkennung kann so mit einem einfachen und kostengünstigen Schaltungsaufbau und einer einfachen Messsignalauswertung durchgeführt werden.

Liegt hingegen eine Unterbrechung einer Motorphase vor, zum Beispiel aufgrund eines durchgetrennten Motorkabels, eines defekten Motorkabels, eines falsch angeschlossenen Motorkabels oder einer durchgebrannten Motorwicklung des Motors, so nimmt die Spannung der ausgewählten Motorphase beim Einschalten des zur unterbrochenen Motorphase gehörenden positiven Leistungsschalters in der positiven Halbwelle der Netzspannung nicht die Zwischenkreisspannung an bzw. beim Einschalten des zur unterbrochenen Motorphase gehörenden negativen Leistungsschalters in der negativen Halbwelle der Netzspannung nicht Null Volt an. Somit kann beim Einschalten eines positiven oder negativen Leistungsschalters des Wechselrichters anhand des Spannungsverlaufs der erfassten Motorphasenspannung erkannt werden, ob eine Motorphasenunterbrechung der jeweiligen Motorphase vorliegt. Bevorzugt werden nacheinander alle positiven oder negativen Leistungsschalter des Wechselrichters einzeln eingeschaltet, um alle Motorphasen auf eine Motorphasenunterbrechung zu prüfen. Diese Motorphasenunterbrechungserkennung kann so mit einem einfachen und kostengünstigen Schaltungsaufbau und einer einfachen Messsignalauswertung durchgeführt werden.

Im Fall eines erkannten Isolationsfehlers oder einer erkannten Motorphasenunterbrechung kann beispielsweise eine nachfolgend geplante Ansteuerung des Motors verhindert / beendet werden und/oder es kann ein Fehlersignal generiert werden. Bei Ausführungsformen, in denen die Antriebsschaltung zudem einen Leistungsfaktorkorrekturfilter (PFC-Filter) enthält, wird dieser im Fall eines erkannten Isolationsfehlers oder einer erkannten Motorphasenunterbrechung vorzugsweise anschließend nicht mehr aktiviert.

Da der Motor während der Isolationsfehlererkennung aufgrund des ausgeschalteten Wechselrichters der Antriebsschaltung nicht aktiv bestromt wird, liegen alle Motorphasen auf dem gleichen Potenzial gegen Masse. Es ist deshalb ausreichend, nur eine Motorphasenspannung einer ausgewählten Motorphase der Motorphasen auszuwerten, um auch Isolationsfehler an den anderen Motorphasen oder am Sternpunkt der Motorwicklungen erkennen zu können. Um diesen Effekt noch besser zu gewährleisten, findet das Erfassen der einen Motorphasenspannung vorzugsweise während eines Motorstillstands statt, sodass keine Spannungen durch einen noch drehenden Rotor des Motors induziert werden können, welche die eine Motorphasenspannung beeinflussen könnten. Im Rahmen der Erfindung können wahlweise aber auch mehrere Motorphasenspannungen ausgewählter Motorphasen erfasst werden.

Die Motoranordnung umfasst insbesondere einen Motor und ein Motorkabel zum Anschließen des Motors an eine Antriebsschaltung. Zu den erkennbaren Isolationsfehlern an den Motorphasen zählen insbesondere Isolationsfehler an den Motorphasen des Motorkabels, an den Motorwicklungen und an einem Sternpunkt der Motorwicklungen.

Die Erfindung ist auf keine spezielle Motorart beschränkt. Bei dem Motor der Motoranordnung handelt es sich insbesondere um einen elektronisch kommutierten Motor wie beispielsweise einen Synchronmotor oder Asynchronmotor, einen Wechselstrommotor, einen Drehstrommotor oder dergleichen.

Der Wechselrichter der Antriebsschaltung weist vorzugsweise eine Wechselrichter-Brückenschaltung, bevorzugt mit mehreren Leistungsschaltern (z.B. MOSFETs oder IGBTs mit antiparallel geschalteten Dioden) auf. Der Wechselrichter ist entsprechend dem angeschlossenen Motor vorzugsweise mehrphasig ausgestaltet. Unter einem positiven Leistungsschalter des Wechselrichters wird ein mit dem Pluspol des Gleichspannungszwischenkreises verbundener Leistungsschalter verstanden, der häufig auch als Highside-Schalter bezeichnet wird. Während einer positiven Halbwelle der Netzspannung wird mindestens ein positiver Leistungsschalter geschlossen, um die parasitären Kapazitäten aufzuladen. Unter einem negativen Leistungsschalter des Wechselrichters wird ein mit dem Minuspol des Gleichspannungszwischenkreises verbundener Leistungsschalter verstanden, der häufig auch als Lowside-Schalter bezeichnet wird. Während einer negativen Halbwelle der Netzspannung wird mindestens ein negativer Leistungsschalter geschlossen, um die parasitären Kapazitäten zu entladen.

Der Gleichspannungszwischenkreis der Antriebsschaltung weist vorzugsweise einen Zwischenkreiskondensator auf. Der Gleichspannungszwischenkreis der Antriebsschaltung ist vorzugsweise über einen Gleichrichter mit einem Wechselstromanschluss verbunden, an welchen das jeweilige Versorgungsnetz angeschlossen werden kann. Der Gleichrichter der Antriebsschaltung ist vorzugsweise als Brückengleichrichter mit mehreren Gleichrichterdioden ausgebildet.

Bei dem Bezugspotenzial handelt es sich beispielsweise um den Minuspol des Gleichspanungszwischenkreises oder um Masse.

In einer Ausgestaltung der Erfindung ist die ausgewählte Motorphase über eine hochohmige Messimpedanz mit dem Bezugspotenzial verbunden und es wird eine entsprechend runtergeteilte Motorphasenspannung der ausgewählten Motorphase erfasst. Unter einer hochohmigen Messimpedanz soll in diesem Zusammenhang ein Widerstandswert von mehreren 100 Kiloohm und mehr verstanden werden. Der Widerstandswert der hochohmigen Messimpedanz beträgt beispielsweise 10 Megaohm. Im Vergleich dazu hat ein kritischer Isolationsfehler der Motorphasen gegenüber dem Schutzleiter einen Widerstandswert von weniger als mehreren 10 Kiloohm. Die Aufladung oder Entladung der parasitären Kapazitäten zwischen den Motorphasen und dem Schutzleiter erfolgt während des ausgeschalteten Wechselrichters über die hochohmige Messimpedanz und im Fall von Isolationsfehlern zusätzlich über entsprechende Fehlerströme. Je kritischer die Isolationsfehler, d.h. je höher die Fehlerströme, umso schneller ist die Spannungstransiente an der Messimpedanz.

In einer Ausgestaltung der Erfindung wird die Motorphasenspannung bzw. die runtergeteilte Motorphasenspannung mittels eines Spannungsteilers erfasst. Vorzugsweise bildet der Spannungsteiler zugleich die hochohmige Messimpedanz. Die mittels eines Spannungsteilers gemessene Messspannung kann in vorteilhafter Weise von einem Analog-Digital-Wandler zum Beispiel eines Mikrocontrollers ausgewertet werden.

Falls die Antriebsschaltung zwischen dem Gleichrichter und dem Gleichspannungszwischenkreis ferner einen Leistungsfaktorkorrekturfilter (PFC-Filter) mit einem Schalter aufweist, wird der Schalter dieses PFC-Filters vor dem Einschalten mindestens eines positiven oder negativen Leistungsschalters des Wechselrichters vorzugsweise ausgeschaltet, um mögliche Gleichstromfehler, die beispielsweise einen Fehlerstromschutzschalter des Typs A beeinträchtigen könnten, auszuschließen.

In einer Ausgestaltung der Erfindung wird der mindestens eine Leistungsschalter des Wechselrichters beim Aufladevorgang bzw. Entladevorgang nur für eine sehr kurze Zeitdauer von beispielsweise wenigen Mikrosekunden eingeschaltet. In dieser kurzen Zeit führt ein Fehlerstrom aufgrund eines vorhandenen Isolationsfehlers noch nicht zum Auslösen einer externen Sicherung wie zum Beispiel eines Fehlerstromschutzschalters. Auch ist eine solche kurze Einwirkzeit bezüglich der physiologischen Wirkung im Fall eines Fehlerstroms über einen Körper unkritischer.

Die erfindungsgemäße Antriebsschaltung zum Antreiben eines elektronisch kommutierten Motors weist einen Gleichspannungszwischenkreis und einen mit dem Gleichspannungszwischenkreis verbundenen Wechselrichter mit einer Brückenschaltung mit wenigstens einem positiven Leistungsschalter und wenigstens einem negativen Leistungsschalter, an den die Motorphasen einer den Motor enthaltenden Motoranordnung anschließbar sind, auf. Die erfindungsgemäße Antriebsschaltung enthält ferner eine Detektionsschaltung zum Erfassen mindestens einer Motorphasenspannung einer ausgewählten Motorphase der Motorphasen gegen ein Bezugspotenzial und eine Steuereinrichtung, die ausgestaltet ist, um die Leistungsschalter des Wechselrichters einzeln ein- und auszuschalten und die Detektionsschaltung zum Erfassen der Motorphasenspannung zu betreiben. Gemäß einem ersten Aspekt der Erfindung ist die Steuereinrichtung außerdem ausgestaltet, um anhand eines Spannungsverlaufs der erfassten Motorphasenspannung festzustellen, ob ein Isolationsfehler an einer der Motorphasen der Motoranordnung vorhanden ist. Gemäß einem zweiten Aspekt der Erfindung ist die Steuereinrichtung außerdem ausgestaltet, um anhand eines Spannungsverlaufs der erfassten Motorphasenspannung festzustellen, ob eine Motorphasenunterbrechung einer der Motorphasen der Motoranordnung vorliegt. Der erste Aspekt und der zweite Aspekt können bevorzugt auch beide vorgesehen sein.

Mit dieser Antriebsschaltung können die gleichen Vorteile wie mit den beiden oben beschriebenen Verfahren zum Erkennen eines Isolationsfehlers bzw. einer Motorphasenunterbrechung erzielt werden. Bezüglich der vorteilhaften Ausgestaltungen und Begriffsdefinitionen wird ebenfalls ergänzend auf die obigen Ausführungen in Zusammenhang mit den Verfahren verwiesen.

In einer Ausgestaltung der Erfindung weist die Detektionsschaltung eine hochohmige Messimpedanz auf, über die die ausgewählte Motorphase mit dem Bezugspotenzial verbunden ist.

In einer Ausgestaltung der Erfindung weist die Detektionsschaltung einen Spannungsteiler zum Erfassen der Motorphasenspannung auf.

In einer Ausgestaltung der Erfindung weist die Antriebsschaltung ferner wenigstens einen zusätzlichen Kondensator auf, der von einer der Motorphasen nach Erde geschaltet ist. Da die Größe der parasitären Kapazitäten des Motors bzw. des Motorkabels gegen den Schutzleiter stark anwendungsabhängig ist, können die parasitären Kapazitäten in besonders kapazitätsarmen Motoraufbauten (z.B. kurzes Motorkabel, kapazitätsarmer Motor) durch zusätzliche Kondensatoren in der Antriebsschaltung, die jeweils von einer Motorphase nach Erde geschaltet sind, erhöht werden. Somit kann das beschriebene Prinzip der Fehlerstromerkennung auf der Motorseite auch in Anwendungen mit kapazitätsarmen Motoranordnungen angewendet werden.

In einer weiteren Ausgestaltung der Erfindung ist der Gleichspannungszwischenkreis eingangsseitig über einen Gleichrichter mit einem Wechselstromanschluss verbunden und ist zwischen dem Gleichrichter und dem Gleichspannungszwischenkreis ferner ein Leistungsfaktorkorrekturfilter (PFC-Filter) mit einem Schalter vorgesehen. In diesem Fall ist die Steuereinrichtung vorzugsweise ausgestaltet, um den Schalter des PFC-Filters vor dem Einschalten mindestens eines positiven oder negativen Leistungsschalters des Wechselrichters auszuschalten.

In einer weiteren Ausgestaltung der Erfindung ist die Steuereinrichtung ferner ausgestaltet, um ein Einschalten des Wechselrichters und/oder des Leistungsfaktorkorrekturfilters (falls vorhanden) nach dem Erfassen der Motorphasenspannung zu verhindern, falls ein Isolationsfehler oder eine Motorphasenunterbrechung festgestellt worden ist.

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnungen besser verständlich.

Darin zeigen, zum Teil schematisch:

Fig. 1    ein Schaltbild einer Antriebsschaltung mit angeschlossenem Motor und verschiedenen möglichen Isolationsfehlern an den Motorphasen;

Fig. 2    ein Schaltbild einer Antriebsschaltung mit angeschlossenem Motor gemäß einem Ausführungsbeispiel der
          Erfindung;

Fig. 3    Diagramme der Steuersignale des Wechselrichters, der Motorphasenspannung und der erfassten runtergeteilten Motorphasenspannung der Isolationsfehlererkennung für die Antriebsschaltung von Fig. 2 während der
          positiven Halbwelle der Netzspannung im fehlerfreien Fall ohne Isolationsfehler;

Fig. 4    Diagramme der Steuersignale des Wechselrichters, der Motorphasenspannung und der erfassten runtergeteilten Motorphasenspannung der Isolationsfehlererkennung für die Antriebsschaltung von Fig. 2 während der
          positiven Halbwelle der Netzspannung im Fall eines Isolationsfehlers an einer der Motorphasen;

Fig. 5    Diagramme der Steuersignale des Wechselrichters, der Motorphasenspannung und der erfassten runtergeteilten Motorphasenspannung der Isolationsfehlererkennung für die Antriebsschaltung von Fig. 2 während der
          negativen Halbwelle der Netzspannung im fehlerfreien Fall ohne Isolationsfehler; und

Fig. 6    Diagramme der Steuersignale des Wechselrichters, der Motorphasenspannung und der erfassten runtergeteilten Motorphasenspannung der Isolationsfehlererkennung für die Antriebsschaltung von Fig. 2 während der
          negativen Halbwelle der Netzspannung im Fall eines Isolationsfehlers an einer der Motorphasen.

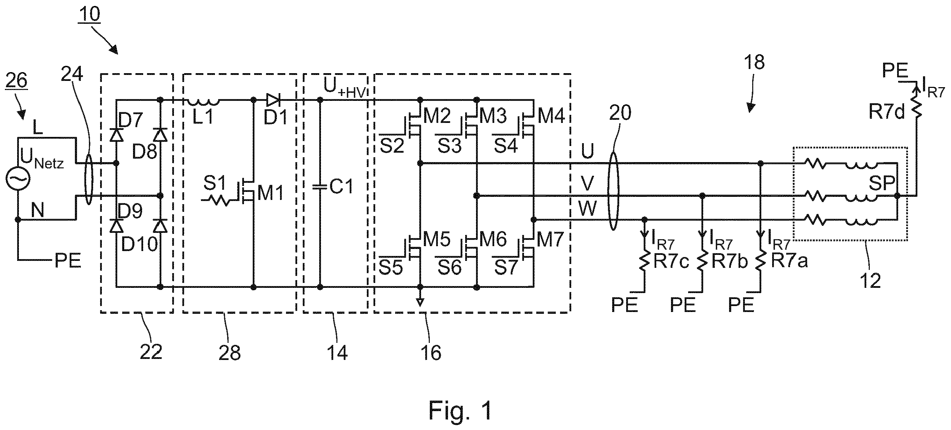

Bezug nehmend auf Fig. 1 soll zunächst die Anwendungsmöglichkeit der vorliegenden Erfindung näher erläutert werden.

Die Antriebsschaltung 10 dient dem Antreiben eines elektronischen kommutierten Motors 12. Im Beispiel von Fig. 1 handelt es sich um einen dreiphasigen bürstenlosen Drehstrommotor 12 mit drei Motorphasen U, V, W, die an einem Sternpunkt SP miteinander verbunden sind. Der Motor 12 wird aus einem Gleichspannungszwischenkreis 14 über einen Wechselrichter 16 gespeist. Der Gleichspannungszwischenkreis 14 weist einen Zwischenkreiskondensator C1 auf, und der Wechselrichter 16 weist eine in diesem Ausführungsbeispiel dreiphasige Wechselrichter-Brückenschaltung mit insgesamt sechs Leistungsschaltern M2 bis M7 (z.B. MOSFETs oder IGBTs mit antiparallel geschalteten Dioden) in seinen Halbbrücken auf. Die drei Motorwicklungen des Motors 12 sind über ein Motorkabel 18 an einen Motorphasenanschluss 20 angeschlossen, der mit den drei Mittelabgriffen der Halbbrücken des Wechselrichters 16 verbunden ist. Der Motor 12 und das Motorkabel 18 haben jeweils drei Motorphasen U, V, W und sind Bestandteile der Motoranordnung.

Eingangsseitig ist der Gleichspannungszwischenkreis 14 über einen Gleichrichter 22 mit einem Wechselstromanschluss 24 verbunden. Über den Wechselstromanschluss 24 kann die Antriebsschaltung 10 mit einem Versorgungsnetz 26 verbunden werden. Im Beispiel von Fig. 1 ist das Versorgungsnetz 26 ein einphasiges Stromnetz, ist die Antriebsschaltung 10 mit dem Phasenleiter L und dem Neutralleiter N des einphasigen Stromnetzes verbunden, und hat das Versorgungsnetz 26 zudem eine Schutzerdung PE. Der Gleichrichter 22 weist in diesem Beispiel eine Gleichrichter-Brückenschaltung mit insgesamt vier Gleichrichterdioden D7 bis D10 auf.

Optional kann zwischen den Gleichrichter 22 und den Gleichspannungszwischenkreis 14 zudem ein Leistungsfaktorkorrekturfilter (PFC-Filter) 28 geschaltet sein. Der PFC-Filter 28 ist in diesem Beispiel in einer Hochsetzsteller-Topologie ausgestaltet und enthält insbesondere eine Induktivität L1, einen Schalter M1 und eine Gleichrichterdiode D1.

Die Antriebsschaltung 10 hat ferner eine Steuereinrichtung (nicht dargestellt in Fig. 1) zum Beispiel in Form eines Mikrocontrollers, die den Schalter M1 des PFC-Filters 28, falls vorhanden, und die Leistungsschalter M2 bis M7 des Wechselrichters 16 über entsprechende Steuersignale S1 bzw. S2..7 ansteuert.

Bei einer solchen Antriebsschaltung 10 gibt es verschiedene Arten von Isolationsfehlern, die auf der Seite des angeschlossenen Motors 12 auftreten können. Es kann zu Isolationsfehlern der Motorphasen U, V, W im Motorkabel 18 sowie zu Isolationsfehlern des Sternpunkts SP der Motorwicklungen des Motors 12 kommen. Die verschiedenen Arten von Isolationsfehlern sind in Fig. 1 als Isolationsfehler mit den Widerständen R7a, R7b, R7c für die Motorphasen U, V, W des Motorkabels 12 bzw. dem Widerstand R7d für den Sternpunkt SP der Motorwicklungen des Motors 12 dargestellt.

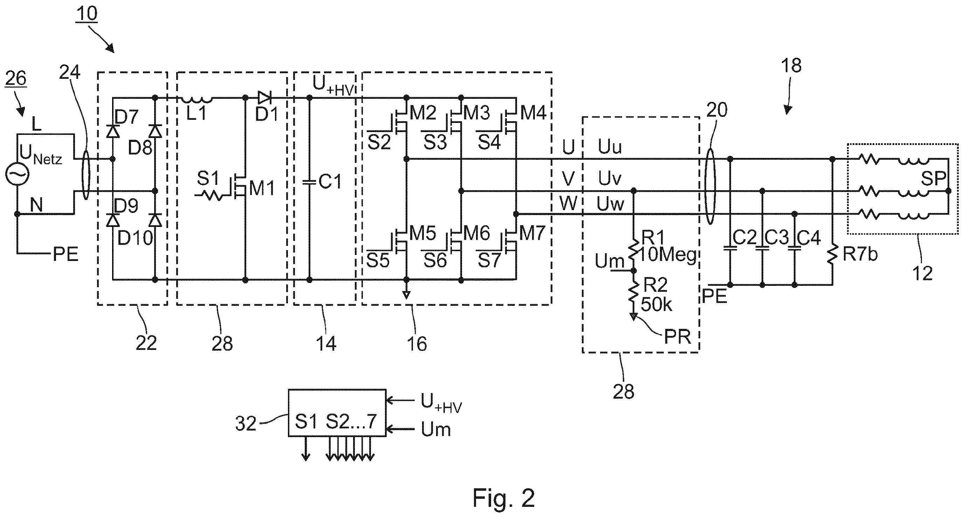

Bezug nehmend auf Fig. 2 werden nun Aufbau und Funktionsweise einer Antriebsschaltung für einen elektronisch kommutierten Motor gemäß einem Ausführungsbeispiel der Erfindung näher erläutert. Dabei sind gleiche bzw. entsprechende Komponenten mit den gleichen Bezugsziffern wie in Fig. 1 gekennzeichnet.

Die Antriebsschaltung 10 von Fig. 2 entspricht im Wesentlichen der Antriebsschaltung von Fig. 1. Zusätzlich zu Gleichrichter 22, optionalem PFC-Filter 28, Gleichspannungszwischenkreis 14 und Wechselrichter 16 enthält die erfindungsgemäße Antriebsschaltung 10 eine Detektionsschaltung 30, mit der alle oben beschriebenen Isolationsfehler an den Motorphasen der Motoranordnung erkannt werden können.

Die Detektionsschaltung 30 enthält eine hochohmige Messimpedanz, die durch einen ersten Widerstand R1 gebildet ist und über den eine ausgewählte Motorphase (hier: V) der Motorphasen U, V, W mit einem Bezugspotenzial PR verbunden ist. Das Bezugspotenzial PR ist beispielsweise der Minuspol des Gleichspannungszwischenkreises 14 oder Masse. Der erste Widerstand R1 hat beispielsweise einen Widerstandswert von 10 Megaohm.

Die Detektionsschaltung 30 weist zudem einen Spannungteiler auf, der durch den ersten Widerstand R1 und einen zweiten Widerstand R2 gebildet ist, die zwischen der Motorphase V und dem Bezugspotenzial PR in Serie geschaltet sind. Der zweite Widerstand R2 hat beispielsweise einen Widerstandswert von 50 Kiloohm. Mit Hilfe dieses Spannungsteilers R1, R2 kann als Messspannung Um eine runtergeteilte Spannung der Motorphasenspannung Uv erfasst werden, die dann von einem Analog-Digital-Wandler der Steuereinrichtung 32 ausgewertet werden kann.

Im Ausführungsbeispiel von Fig. 2 erfasst die Detektionsschaltung 30 die runtergeteilte Motorphasenspannung Um der Motorphase V. In anderen Ausführungsformen der Erfindung können in analoger Weise auch runtergeteilte Motorphasenspannungen Um der anderen Motorphasen U, W oder runtergeteilte Motorphasenspannungen Um mehrerer Motorphasen U, V, W erfasst werden.

In Fig. 2 sind zudem die parasitären Kapazitäten C2, C3, C4 zwischen den Motorphasen U, V, W und der Schutzerdung PE sowie beispielhaft ein Isolationsfehlerwiderstand R7b der Motorphase V gegen die Schutzerdung PE eingezeichnet.

Die Durchführung einer Isolationsfehlererkennung an den Motorphasen U, V, W der Motoranordnung 12, 18 geschieht wie folgt.

Zunächst wird während der positiven Halbwelle der Netzspannung $U_{Netz}$ von der Steuereinrichtung 32 über entsprechende Steuersignale S2..7 mindestens einer der drei positiven Leistungsschalter (Highside-Schalter) M2, M3, M4 des Wechselrichters 32 eingeschaltet, während die drei negativen Leistungsschalter (Lowside-Schalter) M5, M6, M7 dauerhaft ausgeschaltet bleiben. Analog dazu wird während der negativen Halbwelle der Netzspannung $U_{Netz}$ von der Steuereinrichtung 32 über entsprechende Steuersignale S2..7 mindestens einer der negativen Leistungsschalter (Lowside-Schalter) M5, M6, M7 eingeschaltet, während die drei positiven Leistungsschalter (Highside-Schalter) M2, M3, M4 dauerhaft ausgeschaltet bleiben. Hierdurch werden die parasitären Kapazitäten C2, C3, C4 zunächst auf die Zwischenkreisspannung $U_{+HV}$ aufgeladen (positive Halbwelle der Netzspannung) oder entladen (negative Halbwelle der Netzspannung).

Für den Fall, dass die Fehlerstromerkennung in einer Antriebsschaltung 10 mit aktivem PFC-Filter 28 eingesetzt wird, wird dieser aktive PFC-Filter 28 während des Aufladevorgangs zur Verhinderung möglicher Gleichstromfehler durch die Steuereinrichtung 32 über ein entsprechendes Steuersignal S1 vorzugsweise ausgeschaltet, da diese Gleichstromfehler die Funktion eines Fehlerstromschutzschalter vom Typ A beeinträchtigen könnten.

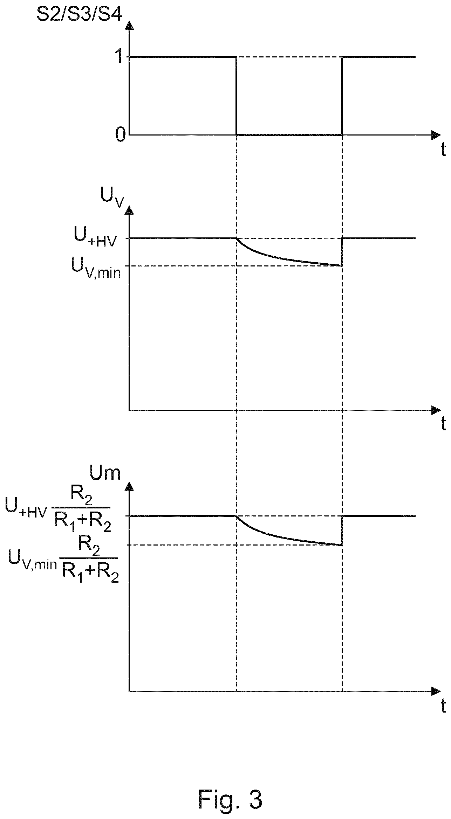

Fig. 3 zeigt die Kurvenverläufe der Steuersignale S2..4 des Wechselrichters 16, der Motorphasenspannung Uv und der erfassten runtergeteilten Motorphasenspannung Um während der Isolationsfehlererkennung für den fehlerfreien Fall während der positiven Halbwelle der Netzspannung $U_{Netz}$.

Nach dem Aufladevorgang werden alle Leistungsschalter M2 bis M7 von der Steuereinrichtung 32 ausgeschaltet. Im fehlerfreien Fall entladen sich die parasitären Kapazitäten C2, C3, C4 dann über den hochohmigen Spannungsteiler R1, R2 der Detektionsschaltung 30. Durch die hohe RC-Zeitkonstante aufgrund des hochohmigen Entladewiderstands sinkt die Spannung an der Motorphase V während der Zeit, in der auch die Leistungsschalter M2, M3, M4 ausgeschaltet sind, nur langsam ab.

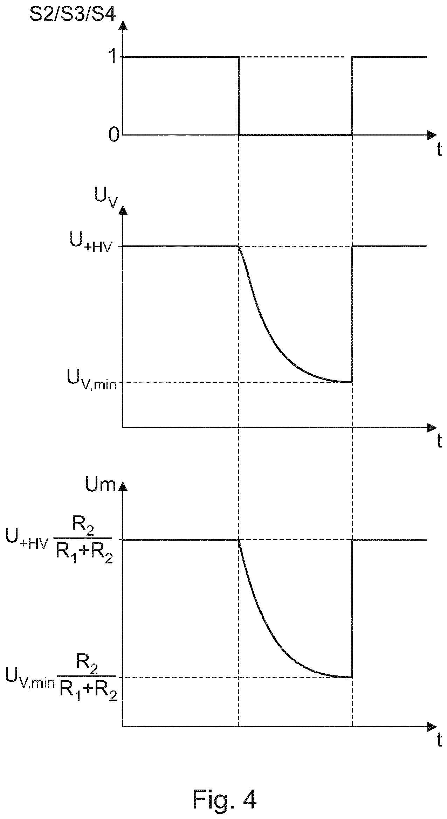

Fig. 4 zeigt die Kurvenverläufe der Steuersignale S2..4 des Wechselrichters 16, der Motorphasenspannung Uv und der erfassten runtergeteilten Motorphasenspannung Um während der Isolationsfehlererkennung für den Fall eines vorhandenen Isolationsfehlers beispielsweise an der Motorphase V der Motoranordnung 12, 18 während der positiven Halbwelle der Netzspannung $U_{Netz}$.

Ist ein Isolationsfehler beispielsweise an der Motorphase V vorhanden, so führt der Entladepfad der parasitären Kapazitäten C2, C3, C4 nicht mehr über den hochohmigen Spannungsteiler R1, R2 der Detektionsschaltung 30, sondern über den vergleichsweise viel niederohmigeren Isolationsfehlerwiderstand R7b. Aus diesem Grund sinkt die Spannung an der Motorphase V während der Zeit, in der auch die positiven Leistungsschalter M2, M3, M4 ausgeschaltet sind, nun viel schneller ab als im fehlerfreien Fall. Der Analog-Digitalwandler der Steuereinrichtung 32 wertet das runtergeteilte Messsignal Um der Motorphasenspannung Uv aus und erkennt anhand des Spannungsverlaufs, ob ein Isolationsfehler an einer der Motorphasen U, V, W oder dem Sternpunkt SP vorhanden ist.

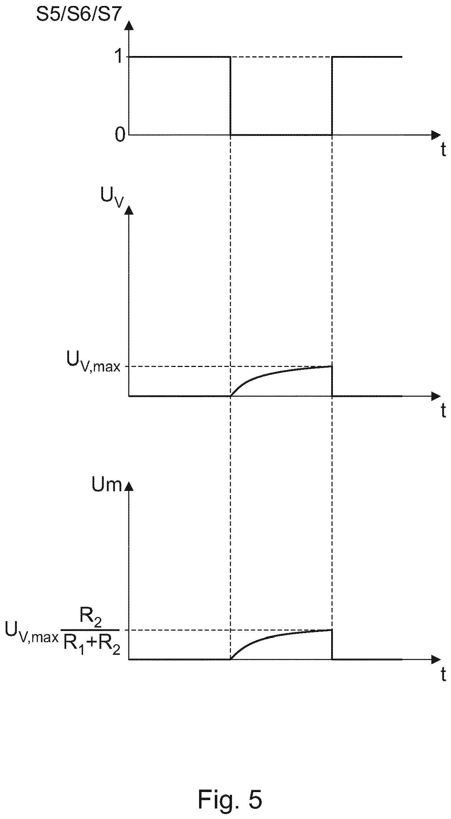

Fig. 5 zeigt die Kurvenverläufe der Steuersignale S5..7 des Wechselrichters 16, der Motorphasenspannung Uv und der erfassten runtergeteilten Motorphasenspannung Um während der Isolationsfehlererkennung für den fehlerfreien Fall während der negativen Halbwelle der Netzspannung $U_{Netz}$.

Nach dem Entladevorgang werden alle Leistungsschalter M2 bis M7 von der Steuereinrichtung 32 ausgeschaltet. Im fehlerfreien Fall laden sich die parasitären Kapazitäten C2, C3, C4 dann über den hochohmigen Spannungsteiler R1, R2 der Detektionsschaltung 30 auf. Durch die hohe RC-Zeitkonstante aufgrund des hochohmigen Entladewiderstands verändert sich die Spannung an der Motorphase V während der Zeit, in der auch die Leistungsschalter M2, M3, M4 ausgeschaltet sind, nur sehr langsam.

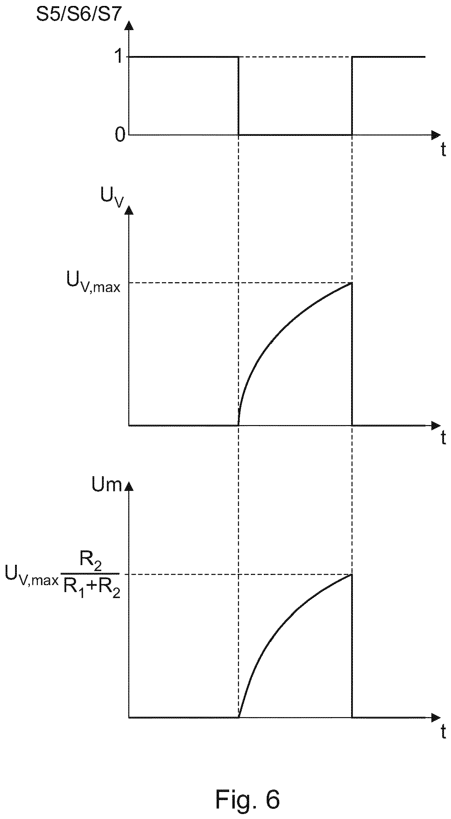

Fig. 6 zeigt die Kurvenverläufe der Steuersignale S5..7 des Wechselrichters 16, der Motorphasenspannung Uv und der erfassten runtergeteilten Motorphasenspannung Um während der Isolationsfehlererkennung für den Fall eines vorhandenen Isolationsfehlers beispielsweise an der Motorphase V der Motoranordnung 12, 18 während der negativen Halbwelle der Netzspannung $U_{Netz}$.

Ist ein Isolationsfehler beispielsweise an der Motorphase V vorhanden, so führt der Aufladepfad der parasitären Kapazitäten C2, C3, C4 nicht mehr über den hochohmigen Spannungsteiler R1, R2 der Detektionsschaltung 30, sondern über den vergleichsweise viel niederohmigeren Isolationsfehlerwiderstand R7b. Aus diesem Grund steigt die Spannung an der Motorphase V während der Zeit, in der auch die positiven Leistungsschalter M2, M3, M4 ausgeschaltet sind, nun viel schneller an als im fehlerfreien Fall. Der Analog-Digitalwandler der Steuereinrichtung 32 wertet das runtergeteilte Messsignal Um der Motorphasenspannung Uv aus und kann anhand des Spannungsverlaufs erkennen, ob ein Isolationsfehler an einer der Motorphasen U, V, W oder dem Sternpunkt SP vorhanden ist.

Da die Größe der parasitären Kapazitäten C2, C3, C4 stark anwendungsabhängig ist, können die parasitären Kapazitäten in besonders kapazitätsarmen Motoraufbauten (z.B. kurzes Motorkabel 18, kapazitätsarmer Motor 12) durch zusätzliche Kondensatoren in der Antriebsschaltung 10, die jeweils von einer Motorphase U, V, W nach Erde geschaltet sind, erhöht werden. Somit kann das beschriebene Prinzip der Fehlerstromerkennung auf der Motorseite auch in Anwendungen mit kapazitätsarmen Motoranordnungen angewendet werden.

In der positiven Halbwelle der Netzspannung $U_{Netz}$ kann der Isolationsfehlerwiderstand R7b durch folgenden Ausdruck berechnet werden:

$$R7b = -\frac{t}{C_{2,3,4} * ln\left(\frac{\frac{R1+R2}{R2} * Um(t)}{U_{+HV}}\right)}$$

wobei t die Zeit ist, $C_{2,3,4}$ die Gesamtkapazität der drei parasitären Kapazitäten C2, C3, C4 ist, und $U_{+HV}$ die Zwischenkreisspannung über dem Gleichspannungszwischenkreis 14 ist.

Aus dem so ermittelten Isolationsfehlerwiderstand R7b lässt sich der maximale Isolationsfehlerstrom, der im Spannungsmaximum der positiven Halbwelle der Netzspannung fließt, wie folgt berechnen:

$$I_{R7,max} = \frac{U_{+HV}}{R7b} = \frac{U_{+HV} * C_{2,3,4} * ln\left(\frac{\frac{R1+R2}{R2} * Um(t)}{U_{+HV}}\right)}{t}$$

Der maximale Fehlerstrom ist der größtmögliche Fehlerstrom, welcher im normalen Motorbetrieb bei eingeschaltetem Wechselrichter fließt, wenn ein Isolationsfehler gegen Schutzerde an einer Motorphase oder ein Isolationsfehler vom Motorsternpunkt nach Schutzerde vorliegt und der Nullvektor (alle Motorphasen gleichzeitig auf high geschaltet) geschaltet wird (nur in diesem Fall nimmt der Sternpunkt die Zwischenkreisspannung an).

In der negativen Halbwelle der Netzspannung $U_{Netz}$ kann der Isolationsfehlerwiderstand R7b durch folgenden Ausdruck berechnet werden:

$$R7b = -\frac{t}{C_{2,3,4} * ln\left(\frac{U_{Netz}(t) - \frac{R1+R2}{R2} * Um(t)}{U_{Netz}}\right)}$$

wobei t die Zeit ist, $C_{2,3,4}$ die Gesamtkapazität der drei parasitären Kapazitäten C2, C3, C4 ist, und $U_{Netz}$ die Netzspannung ist.

Aus dem so ermittelten Isolationsfehlerwiderstand R7b lässt sich der maximale Isolationsfehlerstrom, der im Spannungsmaximum der negativen Halbwelle der Netzspannung fließt, wie folgt berechnen:

$$I_{R7,max} = \frac{U_{+HV}}{R7b} = \frac{U_{+HV} * C_{2,3,4} * ln\left(\frac{U_{Netz}(t) - \frac{R1 + R2}{R2} * Um(t)}{U_{Netz}}\right)}{t}$$

Die Antriebsschaltung 10 mit der erfindungsgemäßen Detektionsschaltung 30 zum Erkennen eines Isolationsfehlers auf der Seite der Motoranordnung 12, 18 kann auch in Kombination mit anderen Versorgungsnetzen 26 und entsprechend angepassten Gleichrichtern 22 eingesetzt werden.

Mit dem anhand der Fig. 1 bis 6 beschriebenen Konzept können zudem auch Motorphasenunterbrechungen erkannt werden, die beispielsweise durch ein durchgetrenntes Motorkabel, ein defektes Motorkabel, ein falsch angeschlossenes Motorkabel oder eine durchgebrannte Motorwicklung des Motors auftreten können.

Zum Erkennen einer Motorphasenunterbrechung wird während der positiven Halbwelle der Netzspannung $U_{Netz}$ von der Steuereinrichtung 32 über entsprechende Steuersignale S2..7 einer der drei positiven Leistungsschalter M2, M3, M4 des Wechselrichters 32 eingeschaltet, während die drei negativen Leistungsschalter M5, M6, M7 dauerhaft ausgeschaltet bleiben, oder wird während der negativen Halbwelle der Netzspannung $U_{Netz}$ von der Steuereinrichtung 32 über entsprechende Steuersignale S2..7 einer der negativen Leistungsschalter M5, M6, M7 eingeschaltet, während die drei positiven Leistungsschalter M2, M3, M4 dauerhaft ausgeschaltet bleiben. Für den Fall, dass die Motorphasenunterbrechungserkennung in einer Antriebsschaltung 10 mit aktivem PFC-Filter 28 eingesetzt wird, wird dieser aktive PFC-Filter 28 durch die Steuereinrichtung 32 über ein entsprechendes Steuersignal S1 vorzugsweise ausgeschaltet.

Im fehlerfreien Zustand ohne eine Motorphasenunterbrechung verhält sich die Motorphasenspannung Uv wie oben beschrieben. Falls hingegen eine Unterbrechung der Motorphase U, V oder W vorliegt, der der eingeschaltete Leistungsschalter M2..7 des Wechselrichters 16 zugeordnet ist, so nimmt die Motorphasenspannung Uv der ausgewählten Motorphase nicht die Zwischenkreisspannung $U_{+HV}$ (positiven Halbwelle der Netzspannung) bzw. nicht 0 Volt (negative Halbwelle der Netzspannung) an.

Bevorzugt werden nacheinander einzeln alle positiven oder negativen Leistungsschalter M2 bis M7 des Wechselrichters 16 eingeschaltet und dann der Spannungsverlauf der ausgewählten Motorphasenspannung Uv ausgewertet, um alle vorhandenen Motorphasen U, V, W auf eine mögliche Unterbrechung zu untersuchen.

BEZUGSZIFFERNLISTE

| | |
|---|---|
| 10 | Antriebsschaltung |
| 12 | Motor |
| 14 | Gleichspannungszwischenkreis |
| 16 | Wechselrichter |
| 18 | Motorkabel |
| 20 | Motorphasenanschluss |
| 22 | Gleichrichter |
| 24 | Wechselstromanschluss |
| 26 | Versorgungsnetz |
| 28 | Leistungsfaktorkorrekturfilter (PFC-Filter) |
| 30 | Detektionsschaltung |
| 32 | Steuereinrichtung |

| | |
|---|---|
| C1 | Zwischenkreiskondensator von 14 |
| C2 - C4 | parasitäre Kapazitäten der Isolationsfehler |
| D1 | Gleichrichterdiode von 28 |
| D7 - D10 | Gleichrichterdioden von 22 |
| L | Phasenleiter von 26 |
| L1 | Induktivität von 28 |
| M1 | Schalter von 28 |
| M2 - M7 | Leistungsschalter von 16 |
| N | Neutralleiter von 26 |
| PE | Schutzerdung |
| PR | Bezugspotenzial |
| R1, R2 | Widerstände von 30 |

| R7 | Isolationsfehler-Widerstand |
| R7a - R7d | Isolationsfehler-Widerstände |
| SP | Sternpunkt von 12 |
| U, V, W | Phasen von 12, 16, 18 |

| $I_{R7}$ | Fehlerstrom |
| S1 | Steuersignal für M1 |
| S2 - S7 | Steuersignale für M2 - M7 |
| $U_{+HV}$ | Zwischenkreisspannung |
| Um | von 30 erfasste Spannung |
| $U_{Netz}$ | Netzspannung |
| Uu, Uv, Uw | Motorphasenspannung |

**Patentansprüche**

1. Verfahren zum Erkennen eines Isolationsfehlers (R7a..d) an einer Motoranordnung (12, 18), deren Motorphasen (U, V, W) an einer Antriebsschaltung (10) angeschlossen sind, wobei die Antriebsschaltung (10) einen Gleichspannungszwischenkreis (14) und einen Wechselrichter (16) mit einer Brückenschaltung mit wenigstens einem positiven Leistungsschalter (M2...4) und wenigstens einem negativen Leistungsschalter (M5...7) aufweist, mit den Schritten:

   Einschalten mindestens eines positiven oder negativen Leistungsschalters (M2...7) des Wechselrichters (16), während alle anderen Leistungsschalter (M2...7) des Wechselrichters (16) ausgeschaltet sind;
   Ausschalten aller Leistungsschalter (M2...7) des Wechselrichters (16);
   Erfassen einer Motorphasenspannung (Uv) mindestens einer ausgewählten Motorphase (V) der Motorphasen (U, V, W) gegen ein Bezugspotenzial (PR), während alle Leistungsschalter (M2...7) des Wechselrichters (16) ausgeschaltet bleiben; und
   Feststellen, ob ein Isolationsfehler (R7a..d) an einer der Motorphasen (U, V, W) der Motoranordnung (12, 18) vorhanden ist, anhand eines Spannungsverlaufs der erfassten Motorphasenspannung (Uv).

2. Verfahren zum Erkennen einer Motorphasenunterbrechung an einer Motoranordnung (12, 18), deren Motorphasen (U, V, W) an einer Antriebsschaltung (10) angeschlossen sind, wobei die Antriebsschaltung (10) einen Gleichspannungszwischenkreis (14) und einen Wechselrichter (16) mit einer Brückenschaltung mit wenigstens einem positiven Leistungsschalter (M2...4) und wenigstens einem negativen Leistungsschalter (M5...7) aufweist, mit den Schritten:

   Einschalten mindestens eines positiven oder negativen Leistungsschalters (M2...7) des Wechselrichters (16), während alle anderen Leistungsschalter (M2...7) des Wechselrichters (16) ausgeschaltet sind;
   Erfassen einer Motorphasenspannung (Uv) mindestens einer ausgewählten Motorphase (V) der Motorphasen (U, V, W) gegen ein Bezugspotenzial (PR); und
   Feststellen, ob eine Motorphasenunterbrechung einer der Motorphasen (U, V, W) der Motoranordnung (12, 18) vorliegt, anhand eines Spannungsverlaufs der erfassten Motorphasenspannung (Uv).

3. Verfahren nach Anspruch 1 oder 2, bei welchem
   die ausgewählte Motorphase (V) über eine hochohmige Messimpedanz (R1) mit dem Bezugspotenzial (PR) verbunden ist; und
   eine runtergeteilte Motorphasenspannung (Um) der ausgewählten Motorphase (V) erfasst wird.

4. Verfahren nach einem der Ansprüche 1 bis 3, bei welchem
   die Motorphasenspannung (Uv) oder die runtergeteilte Motorphasenspannung (Um) mittels eines Spannungsteilers (R1, R2) erfasst wird.

5. Verfahren nach einem der Ansprüche 1 bis 4, bei welchem
   der Gleichspannungszwischenkreis (14) der Antriebsschaltung (10) eingangsseitig über einen Gleichrichter (22) mit einem Wechselstromanschluss (24) verbunden ist und die Antriebsschaltung (10) zwischen dem Gleichrichter (22) und dem Gleichspannungszwischenkreis (14) ferner einen Leistungsfaktorkorrekturfilter (28) mit einem Schalter (M1) aufweist; und
   der Schalter (M1) des Leistungsfaktorkorrekturfilters (28) vor dem Einschalten mindestens eines positiven oder negativen Leistungsschalters (M2...7) des Wechselrichters (16) ausgeschaltet wird.

6.  Antriebsschaltung (10) zum Antreiben eines elektronisch kommutierten Motors (12), aufweisend:

    einen Gleichspannungszwischenkreis (14); und
    einen mit dem Gleichspannungszwischenkreis (14) verbundenen Wechselrichter (16) mit einer Brückenschaltung mit wenigstens einem positiven Leistungsschalter (M2...4) und wenigstens einem negativen Leistungsschalter (M5...7), an den die Motorphasen (U, V, W) einer den Motor (12) enthaltenden Motoranordnung (12, 18) anschließbar sind,
    **gekennzeichnet durch**
    eine Detektionsschaltung (30) zum Erfassen einer Motorphasenspannung (Uv) mindestens einer ausgewählten Motorphase (V) der Motorphasen (U, V, W) gegen ein Bezugspotenzial (PR); und
    eine Steuereinrichtung (32), die ausgestaltet ist, um die Leistungsschalter (M2...7) des Wechselrichters (16) einzeln ein- und auszuschalten und die Detektionsschaltung (30) zum Erfassen der Motorphasenspannung (Uv) zu betreiben,
    wobei die Steuereinrichtung (32) ferner ausgestaltet ist, um anhand eines Spannungsverlaufs der erfassten Motorphasenspannung (Uv) festzustellen, ob ein Isolationsfehler (R7a..d) an einer der Motorphasen (U, V, W) der Motoranordnung (12, 18) vorhanden ist, und/oder ausgestaltet ist, um anhand eines Spannungsverlaufs der erfassten Motorphasenspannung (Uv) festzustellen, ob eine Motorphasenunterbrechung einer der Motorphasen (U, V, W) der Motoranordnung (12, 18) vorliegt.

7.  Antriebsschaltung nach Anspruch 6, bei welcher
    die Detektionsschaltung (30) eine hochohmige Messimpedanz (R1) aufweist, über die eine ausgewählte Motorphase (V) mit dem Bezugspotenzial (PR) verbunden ist.

8.  Antriebsschaltung nach Anspruch 6 oder 7, bei welcher
    die Detektionsschaltung (30) einen Spannungsteiler (R1, R2) zum Erfassen der Motorphasenspannung (Uv) aufweist.

9.  Antriebsschaltung nach einem der Ansprüche 6 bis 8, bei welcher
    die Antriebsschaltung (10) ferner wenigstens einen zusätzlichen Kondensator aufweist, der von einer der Motorphasen (U, V, W) nach Erde geschaltet ist.

10. Antriebsschaltung nach einem der Ansprüche 6 bis 9, bei welcher
    der Gleichspannungszwischenkreis (14) eingangsseitig über einen Gleichrichter (22) mit einem Wechselstromanschluss (24) verbunden ist;
    zwischen dem Gleichrichter (22) und dem Gleichspannungszwischenkreis (14) ferner ein Leistungsfaktorkorrekturfilter (28) mit einem Schalter (M1) vorgesehen ist; und
    die Steuereinrichtung (32) ausgestaltet ist, um den Schalter (M1) des Leistungsfaktorkorrekturfilters (28) vor dem Einschalten mindestens eines positiven oder negativen Leistungsschalters (M2...7) des Wechselrichters (16) auszuschalten.

11. Antriebsschaltung nach einem der Ansprüche 6 bis 10, bei welcher
    die Steuereinrichtung (32) ausgestaltet ist, um ein Einschalten des Wechselrichters (16) und/oder des Leistungsfaktorkorrekturfilters (28) nach dem Erfassen der Motorphasenspannung (Uv) zu verhindern, falls ein Isolationsfehler (R7a..d) oder eine Motorphasenunterbrechung festgestellt worden ist.

Fig. 1

Fig. 2

Fig. 3

S2/S3/S4

$U_V$

$U_{+HV}$

$U_{V,min}$

Um

$U_{+HV} \dfrac{R_2}{R_1+R_2}$

$U_{V,min} \dfrac{R_2}{R_1+R_2}$

Fig. 4

Fig. 5

Fig. 6

Europäisches
Patentamt

European
Patent Office

Office européen
des brevets

# EUROPÄISCHER RECHERCHENBERICHT

**Nummer der Anmeldung**

EP 19 19 0280

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 11 2014 002853 T5 (MITSUBISHI ELECTRIC CORP [JP]) 3. März 2016 (2016-03-03) | 1,3-11 | INV. |
| Y | * das ganze Dokument * | 2 | H02P29/024 H02H7/08 |
| | ----- | | |
| X | US 2009/195205 A1 (IDE YUJI [JP]) 6. August 2009 (2009-08-06) | 2-10 | ADD. |
| Y | * das ganze Dokument * | 2 | G01R31/34 G01R27/02 |
| A | | 1 | |
| | ----- | | |
| X | EP 1 681 575 A1 (FANUC LTD [JP]) 19. Juli 2006 (2006-07-19) | 1,3-11 | |
| A | * das ganze Dokument * | 2 | |
| | ----- | | |
| A | GRUBIC S ET AL: "A survey of testing and monitoring methods for stator insulation systems in induction machines", CONDITION MONITORING AND DIAGNOSIS, 2008. CMD 2008. INTERNATIONAL CONFERENCE ON, IEEE, PISCATAWAY, NJ, USA, 21. April 2008 (2008-04-21), Seiten 196-203, XP031292477, ISBN: 978-1-4244-1621-9 * das ganze Dokument * | 1-11 | |
| | ----- | | |

**RECHERCHIERTE SACHGEBIETE (IPC)**

H02P
H02H
G01R

Der vorliegende Recherchenbericht wurde für alle Patentansprüche erstellt

| Recherchenort | Abschlußdatum der Recherche | Prüfer |
|---|---|---|
| München | 20. November 2019 | Wimböck, Thomas |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.............................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 19 0280

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-11-2019

| Im Recherchenbericht angeführtes Patentdokument | Datum der Veröffentlichung | Mitglied(er) der Patentfamilie | Datum der Veröffentlichung |
|---|---|---|---|
| DE 112014002853 T5 | 03-03-2016 | CN 105358997 A | 24-02-2016 |
| | | CN 107621572 A | 23-01-2018 |
| | | DE 112014002853 T5 | 03-03-2016 |
| | | JP 5705382 B1 | 22-04-2015 |
| | | JP 6181769 B2 | 16-08-2017 |
| | | JP 6345312 B2 | 20-06-2018 |
| | | JP 2017142269 A | 17-08-2017 |
| | | JP WO2015075821 A1 | 16-03-2017 |
| | | JP WO2015076075 A1 | 16-03-2017 |
| | | KR 20160015332 A | 12-02-2016 |
| | | TW 201534937 A | 16-09-2015 |
| | | TW 201700984 A | 01-01-2017 |
| | | US 2016377670 A1 | 29-12-2016 |
| | | US 2018340971 A1 | 29-11-2018 |
| | | WO 2015075821 A1 | 28-05-2015 |
| | | WO 2015076075 A1 | 28-05-2015 |
| US 2009195205 A1 | 06-08-2009 | CN 101499773 A | 05-08-2009 |
| | | JP 5065192 B2 | 31-10-2012 |
| | | JP 2009204600 A | 10-09-2009 |
| | | KR 20090084687 A | 05-08-2009 |
| | | US 2009195205 A1 | 06-08-2009 |
| EP 1681575 A1 | 19-07-2006 | CN 1819412 A | 16-08-2006 |
| | | DE 602006000132 T2 | 10-07-2008 |
| | | EP 1681575 A1 | 19-07-2006 |
| | | JP 4554501 B2 | 29-09-2010 |
| | | JP 2006226993 A | 31-08-2006 |
| | | US 2006158197 A1 | 20-07-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6043664 A